Europäisches Patentamt

European Patent Office

Office européen des brevets

(19)

(11) Publication number: **0 028 490**
**B1**

(12) **EUROPEAN PATENT SPECIFICATION**

(45) Date of publication of patent specification: **21.12.83**

(21) Application number: **80303803.3**

(22) Date of filing: **27.10.80**

(51) Int. Cl.³: **H 01 L 21/26,**
**H 01 L 23/02, H 01 L 23/56**

(54) Integrated circuit with Alpha radiation shielding means.

(30) Priority: **02.11.79 GB 7938118**
**02.11.79 GB 7938119**
**03.11.79 GB 7938134**

(43) Date of publication of application:
**13.05.81 Bulletin 81/19**

(45) Publication of the grant of the patent:
**21.12.83 Bulletin 83/51**

(84) Designated Contracting States:
**BE DE FR GB IT LU NL**

(73) Proprietor: **BURROUGHS CORPORATION**
**Burroughs Place**
**Detroit, Michigan 48232 (US)**

(72) Inventor: **Wilkinson, John Malcolm**
**48 Newton Crescent.**
**Dunblane Perthshire Scotland (GB)**

(74) Representative: **Kirby, Harold Douglas Benson**
**et al,**
**Marlborough Lodge 14 Farncombe Road**
**Worthing West Sussex BN11 2BT (GB)**

(56) References cited:
EP - A - 0 021 643
GB - A - 2 039 145

ELECTRONIC DESIGN, vol. 26, no. 11, May
1978, page 37 Rochelle Park, U.S.A. "Alpha
particles may be cause of soft errors in memory"
ELECTRONICS, vol. 51, no. 12, June 1978,
pages 42-43 New York, U.S.A. "Dynamic
memories racked by radiation"

(56) References cited:
17th ANNUAL PROCEEDINGS RELIABILITY
PHYSICS 1979, 24th-26th April 1979, pages 13-
22 San Francisco, California E.S.M. MEIERAN et
al.: "Measurement of alpha particle radioactivity
in IC device packages"

Courier Press, Leamington Spa, England.

Integrated circuit with $\alpha$-radiation shielding means

## Background to the invention

### 1. Field of the invention

The present invention relates to integrated circuits and to methods and apparatus for the shielding of integrated circuits from bombardment by ionising radiation.

### 2. The prior art

The trend in the design and manufacture of integrated circuits, especially those intended for memory storage of informational data, for use in conjunction with data processing equipment, is towards the creation of larger area circuits having on them an increased number of yet smaller components.

An error causing mechanism exists not encountered in the operation of small area integrated circuit memories, having physically large component members, whereby the passage of an alpha particle into the substance of the integrated circuit causes, by the dissipation of its kinetic energy, the generation of sufficient hole-electron pairs to disrupt the integrity of stored data. A large area circuit, presenting a larger target, has a higher probability of being struck by an alpha particle than does a small one. Likewise, a small memory storage cell, requiring only a small number of electrons to be retained for the storage of a binary digit, is more easily disrupted by the sudden injection of alpha generated charge than is a larger cell which requires a large number of electrons for data digit storage.

As cell size decreases, there exists a critical limit, below which an intruding alpha particle is able to disrupt the stored data in several physically adjacent data storage cells. The process of inbuilt error correction, an old art in the design and operation of semiconductor memories, then becomes difficult to achieve and hardware consuming, as it is necessary to correct a plurality of erroneous adjacent bits, requiring long, redundant codes to be added to the stored data. Memory efficiency must suffer if this course is chosen.

The alpha particle problem has proved particularly troublesome in the development of high capacity, charge storage memories. It has become apparent that a soft error rate must be accepted as integral with the operation such integrated circuits. In order to successfully exploit the capacity of such devices, the usual design process of simply scaling and combining earlier, lower capacity memory device designs has largely been abandoned, memory cells in the high capacity devices having higher charge storage per unit area than their earlier counterparts. This has increased the number of stored electrons per memory cell, and so decreased the likelehood of a charge induced error. Other improvements have been incorporated, such as the employment of more efficient electron collectors for each memory cell, so that a smaller number of residual electrons may be interpreted as the presence of a stored binary digit. Threshold levels have also been changed, so that a higher noise immunity is present. The alpha particle problem promises to become increasingly severe as further attempts are made to increase data storage capacity per device. In particular, as new wafer scale circuits are introduced, where the entire surface of a silicon wafer, several inches in diameter, is used for the fabrication of a single circuit, the error rates of a few per hour, presently encountered in the 64k bit memories, will be increased to one every few seconds, thanks to the enormous relative increase in area.

It has been shown that the alpha particles, responsible for charge induced errors, originate from radioactive decay of foreign inclusions in the material used to fabricate the integrated circuit case. The few parts per million of radioactive impurities, present in the materials of the case, emit a sufficiency of alpha particles as nuclear decay products, to cause an unacceptably high probability of the collision of an alpha particle with signal bearing or storage elements in the integrated circuit. While the integrated circuit case does indeed protect the integrated circuit from terrestrial and other sources of background radiation, it itself contributes to the problem setting a lower limit on the number of particles colliding with the integrated circuit every hour.

Accordingly, it is desirable to find means whereby integrated circuits may be protected from the incidence thereon of alpha particles and which is free from radioactive inclusions.

It has already been proposed to attack this problem by devising new packaging material processes, or applying protective coatings to the upper surface of the chip. The present invention is based on this latter approach, and provides a particularly convenient and satisfactory form of protective coating.

The invention consists in an integrated circuit fabricated on a silicon surface and protected from the effects of ionising radiation by a coating applied to its upper surface, characterised in that said coating consists of a layer of polycrystalline silicon at least 10 microns thick, said layer being continuously deposited over said integrated circuit so as to sandwich said circuit between itself and said surface and said polycrystalline silicon being substantially free from radio-active inclusions.

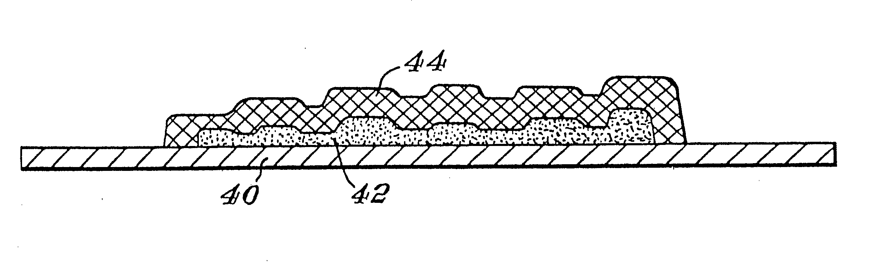

The single Figure of the accompanying drawings shows an integrated circuit having deposited thereover a continuous layer of semiconducting material.

As shown in the drawing, a silicon slice (40) has an integrated circuit (42) fabricated thereon. As a final stage of fabrication, a layer of polycrystalline silicon (44) is deposited over the entire surface of the integrated circuit.

The polycrystalline silicon layer is at least ten microns thick. It is the same style of layer as is used in the normal course of fabrication of charge storage semiconductor memory integrated circuits.

The silicon slice (40) is mounted into an integrated circuit enclosure in a completely normal manner, as a last stage of integrated circuit manufacture.

It is to be appreciated that the polycrystalline silicon layer must meet the electrical insulation criterion for such deposition over an integrated circuit, and must be free from radio-active inclusions and be thick enough to prevent the through-passage of alpha particles with energies up to 10 MeV.

The integrated circuit (42) is thus protected by a complete shielding, being surrounded by silicon above and below.

## Claim

An integrated circuit fabricated on a silicon surface and protected from the effects of ionising radiation by a coating applied to its upper surface, characterised in that said coating consists of a layer of polycrystalline silicon at least 10 microns thick, said layer being continuously deposited over said integrated circuit so as to sandwich said circuit between itself and said surface, and said polycrystalline silicon being substantially free from radio-active inclusions.

## Revendication

Circuit intégré fabriqué sur une surface de silicium et protégé des effets des radiations ionisantes par un revêtement appliqué sur sa surface supérieure, circuit caractérisé en ce que ce revêtement est constitué par une couche de silicium polycrystallin d'au moins 10 microns d'épaisseur, cette couche étant déposée de façon continue sur le circuit intégré de manière à prendre ce circuit en sandwich entre elle-même et la surface de silicium servant de substrat, ce silicium polycrystallin étant parfaitement exempt d'inclusions radioactives.

## Patentanspruch

Auf einer Siliziumfläche angeordnet integrierte Schaltung, die gegenüber Ionenstrahlung durch eine auf ihre Oberfläche aufgebrachte Beschichtung geschützt ist, dadurch gekennzeichnet, daß die Beschichtung aus einer Schicht polykristallinem Silizium mit einer Dicke von mindestens 10 Mikromillimeter besteht, die gleichmäßig auf die integriert Schaltung aufgebracht ist und die integrierte Schaltung zwischen sich und der Siliziumfläche einschließt und daß das polykristalline Silizium weitestegehend frei von radioaktiven Einschlüssen ist.